# EUROPEAN PATENT APPLICATION

(11) **EP 4 708 674 A1**
(43) Date of publication of application: **11.03.2026**
(21) Application number: 25200272.0
(22) Date of filing: 04.09.2025
(51) Int. Cl.: H03B 5/14, H03B 5/26, H03B 5/42, H03B 17/00, H03L 7/02

(54) **SPURIOUS SUPPRESSION CIRCUIT**

(30) Priority: 09.09.2024 US 202463692369 P
(71) Applicant: Nanowave Technologies Inc., Etobicoke, Ontario M8W 4W3 (CA)
(72) Inventor: HALL, Trevor James, Ottawa, K4M 1J3 (CA); NICHOLLS, Charles, William, Tremlett, Nepean, Ontario, K2G 4Y7 (CA)
(74) Representative: Abel & Imray LLP

(57) **Abstract**

A circuit and method for suppressing, in a delay line oscillator, modes spaced by the reciprocal of the oscillator delay that are not located at the center frequency of the mode selection filter that sets the oscillatory mode. The circuit may include: a frequency discriminator configured to receive a delay line output and provide a discriminator output having a plurality of oscillatory modes; a first phase shifter configured to receive the discriminator output and apply a phase shift compensating for a mixer port phase differential; a mixer configured to provide a mixer output having a DC component proportional to a phase difference between inputs received at first and second mixer ports; a second phase shifter configured to receive the mixer output and to output a phase modulated signal; and a circuit coupler configured to provide a first circuit coupler output as an RF output of the circuit, and to provide a second circuit coupler output as an input to the delay line.

## Description

### FIELD

The present disclosure relates generally to radio frequency (RF) systems, and more particularly to circuits for suppressing spurious signals.

### BACKGROUND

Oscillators having low phase noise and a wide tuning bandwidth are desirable for radio equipment including telecommunications, RADAR, and electromagnetic sensor systems and associated test and measurement equipment. A delay line oscillator is a type of oscillator that uses a delay line as its main frequency determining element, and in which a feedback path has a delay that is independent of frequency.

In a delay line oscillator, such as an optoelectronic oscillator (OEO), the oscillatory conditions are met at multiple frequencies spaced by the reciprocal of the delay. Even if a single mode is selected, unwanted adjacent modes can be a source of spurious signals in the oscillator and may reduce system performance.

It remains desirable to develop improvements and advancements in relation to delay line oscillators, to overcome shortcomings of known techniques, and to provide additional advantages thereto.

This section is intended to introduce various aspects of the art, which may be associated with the present disclosure. This discussion is believed to assist in providing a framework to facilitate a better understanding of particular aspects of the present disclosure. Accordingly, it should be understood that this section should be read in this light, and not necessarily as admissions of prior art.

### BRIEF DESCRIPTION OF THE DRAWINGS

Embodiments of the present disclosure will now be described, by way of example only, with reference to the attached Figures.
FIG. 1 is a block diagram of a known dual loop OEO including a short fiber and a long fiber.
FIG. 2 is a block diagram of a circuit, such as an electrical oscillator with spurious suppression circuit, according to an embodiment of the present disclosure.
FIG. 3 is a block diagram of a circuit, such as an optical oscillator with spurious suppression circuit, according to an embodiment of the present disclosure.
FIG. 4 is a graph showing original spurious signals as well as suppressed spurious signals based on measured performance of a feedforward multimode spurious suppression circuit according to an embodiment of the present disclosure.
FIG. 5 is a graph showing spurious signals without suppression in an implementation.
FIG. 6 is a graph showing suppressed spurious signals based on measured performance of a feedforward multimode spurious suppression circuit applied to the spurious signals of FIG. 5 according to an embodiment of the present disclosure.
FIG. 7 is a block diagram of a circuit, such as an electrical oscillator with spurious suppression circuit with a feedback architecture to suppress spurs, according to an embodiment of the present disclosure.
FIG. 8 is a block diagram of a circuit, such as an optical oscillator with spurious suppression circuit with a feedback architecture to suppress spurs, according to an embodiment of the present disclosure.
FIG. 9 is a flow chart illustrating a method of spurious signal suppression, according to an embodiment of the present disclosure.
FIG. 10 is a block diagram of an example computerized device or system that may be used in implementing one or more aspects or components of an embodiment of a spurious suppression circuit in accordance with embodiment of the present disclosure.

Throughout the drawings, sometimes only one or fewer than all of the instances of an element visible in the view are designated by a lead line and reference character, for the sake only of simplicity and to avoid clutter. It will be understood, however, that in such cases, in accordance with the corresponding description, that all other instances are likewise designated and encompassed by the corresponding description.

### DETAILED DESCRIPTION

A circuit and method for suppressing, in a delay line oscillator, modes spaced by the reciprocal of the oscillator delay that are not located at the center frequency of the mode selection filter that sets the oscillatory mode. The circuit may include: a frequency discriminator configured to receive a delay line output and provide a discriminator output having a plurality of oscillatory modes; a first phase shifter configured to receive the discriminator output and apply a phase shift compensating for a mixer port phase differential; a mixer configured to provide a mixer output having a DC component proportional to a phase difference between inputs received at first and second mixer ports; a second phase shifter configured to receive the mixer output and to output a phase modulated signal; and a circuit coupler configured to provide a first circuit coupler output as an RF output of the circuit, and to provide a second circuit coupler output as an input to the delay line.

The following are examples of systems and methods relating to a spurious suppression circuit in accordance with embodiments of the present disclosure.

In an aspect, the present disclosure provides a circuit comprising: a delay line configured to provide a delay line output; a first coupler configured to receive the delay line output and to generate a discriminator input signal and a mixer input signal; a frequency discriminator having an insertion phase error proportional to an offset from a center frequency, the frequency discriminator configured to receive the discriminator input signal and provide a discriminator output having a plurality of oscillatory modes; a second coupler configured to receive the discriminator output and to generate a first phase shifter input and a second phase shifter input; a first phase shifter configured to receive the first phase shifter input and apply a phase shift establishing a mixer port phase differential and to generate a first phase shifter output; a mixer configured to provide a mixer output having a DC component proportional to a phase difference between inputs received at first and second mixer ports, the first and second mixer ports being offset in phase by the mixer port phase differential, the first mixer port configured to receive the mixer input signal and the second mixer port configured to receive the first phase shifter output; a second phase shifter configured to receive the mixer output and to phase modulate the second phase shifter input based on the DC component and to output a phase modulated signal; an RF amplifier configured to receive the phase modulated signal, and output an amplified phase modulated signal to an input of the delay line; and a circuit coupler configured to receive the amplified phase modulated signal and to provide a first circuit coupler output as an RF output of the circuit, and to provide a second circuit coupler output as an input to the delay line.

The circuit may further comprise: a first suppression circuit amplifier configured to receive the discriminator input signal from the first coupler and to provide an amplified discriminator input signal to the frequency discriminator; and a second suppression circuit amplifier configured to receive the first phase shifter input of the second coupler and to provide an amplified first phase shifter input to the first phase shifter.

The circuit may further comprise a loop filter coupled between the mixer and the second phase shifter. The loop filter may comprise a low pass filter for filtering a non-DC component.

The mixer may comprise a double balanced mixer, the first mixer port being in-phase and the second mixer port being in-quadrature relative to the first mixer port.

The mixer port phase differential may comprise 90 degrees.

The frequency discriminator may comprise a resonator.

The frequency discriminator may comprise a delay line.

The delay line may be characterized by a delay line length and the delay line output includes a plurality of modes spaced apart based on a reciprocal of the delay line length.

The center frequency may be a desired oscillatory mode.

The first phase shifter may comprise an electronic phase shifter.

The second phase shifter may comprise a voltage controlled phase shifter.

The signal source may comprise a surface acoustic wave oscillator.

The circuit may further comprise a set of optical domain components comprising the signal source, the delay line, a downconverter and a modulator, the downconverter configured to receive and convert the delay line output to an RF domain and the modulator configured to receive the control signal from the second phase shifter.

The signal source may comprise a laser.

The delay line may comprise an optical delay line.

The downconverter may comprise a photodiode.

The modulator may comprise a Mach-Zehnder modulator.

In another aspect, the present disclosure provides a method of spurious signal suppression, comprising: receiving, at a frequency discriminator having an insertion phase error proportional to an offset from a center frequency, a delay line output; providing, at the frequency discriminator, a discriminator output having a plurality of oscillatory modes; receiving, at a first phase shifter, the discriminator output; applying, at the first phase shifter, a phase shift compensating for a mixer port phase differential; providing, at a mixer, a mixer output having a DC component proportional to a phase difference between inputs received at first and second mixer ports, the first and second mixer ports being offset in phase by the mixer port phase differential, the first mixer port configured to receive the delay line output and the second mixer port configured to receive the discriminator output; receiving, at a second phase shifter, the mixer intermediate frequency output; and providing, at the second phase shifter, a phase modulated signal; receiving, at a circuit coupler, the phase modulated signal; and providing, at the circuit coupler, a first circuit coupler output as an RF output of the circuit, and a second circuit coupler output as an input to the delay line.

In a further aspect, the present disclosure provides a non-transient computer-readable storage medium having instructions embodied thereon, the instructions being executable by one or more processors to perform a method of spurious signal suppression, the method comprising: receiving, at a frequency discriminator having an insertion phase error proportional to an offset from a center frequency, a delay line output; providing, at the frequency discriminator, a discriminator output having a plurality of oscillatory modes; receiving, at a first phase shifter, the discriminator output; applying, at the first phase shifter, a phase shift compensating for a mixer port phase differential; providing, at a mixer, a mixer output having a DC component proportional to a phase difference between inputs received at first and second mixer ports, the first and second mixer ports being offset in phase by the mixer port phase differential, the first mixer port configured to receive the delay line output and the second mixer port configured to receive the discriminator output; receiving, at a second phase shifter, the mixer intermediate frequency output; and providing, at the second phase shifter, a phase modulated signal; receiving, at a circuit coupler, the phase modulated signal; and providing, at the circuit coupler, a first circuit coupler output as an RF output of the circuit, and a second circuit coupler output as an input to the delay line.

In another aspect, the present disclosure provides a circuit, comprising: a delay line configured to provide a delay line output; a voltage-controlled phase shifter configured to receive the delay line output and to phase modulate the delay line output and to output a phase modulated signal; a first coupler configured to receive phase modulated signal and to generate a discriminator input signal and a mixer input signal; a frequency discriminator having an insertion phase error proportional to an offset from a center frequency, the frequency discriminator configured to receive the discriminator input signal and provide a discriminator output having a plurality of oscillatory modes; a second coupler configured to receive the discriminator output and to generate a first phase shifter input and a second coupler output; an electronic phase shifter configured to receive the first phase shifter input and apply a phase shift establishing a mixer port phase differential and to generate a first phase shifter output; a mixer configured to provide a mixer output having a DC component proportional to a phase difference between inputs received at first and second mixer ports, the first and second mixer ports being offset in phase by the mixer port phase differential, the first mixer port configured to receive the mixer input signal and the second mixer port configured to receive the first phase shifter output; an RF amplifier configured to receive the second coupler output, and output an amplified phase modulated signal to an input of the delay line; and a circuit coupler configured to receive the amplified phase modulated signal and to provide a first circuit coupler output as an RF output of the circuit, and to provide a second circuit coupler output as an input to the delay line.

For the purpose of promoting an understanding of the principles of the disclosure, reference will now be made to the features illustrated in the drawings and specific language will be used to describe the same. It will nevertheless be understood that no limitation of the scope of the disclosure is thereby intended. Any alterations and further modifications, and any further applications of the principles of the disclosure as described herein are contemplated as would normally occur to one skilled in the art to which the disclosure relates. It will be apparent to those skilled in the relevant art that some features that are not relevant to the present disclosure may not be shown in the drawings for the sake of clarity.

Certain terms used in this application and their meaning as used in this context are set forth in the description below. To the extent a term used herein is not defined, it should be given the broadest definition persons in the pertinent art have given that term as reflected in at least one printed publication or issued patent. Further, the present processes are not limited by the usage of the terms shown below, as all equivalents, synonyms, new developments and terms or processes that serve the same or a similar purpose are considered to be within the scope of the present disclosure.

Optoelectronic oscillators provide the lowest phase noise widest bandwidth signal sources currently available in the microwave and millimeter frequency ranges. Commercial units are becoming available which are setting a new standard with respect to system phase noise and as a result system sensitivity.

In an OEO with best in class close in phase noise at X band, a phase noise value of -163 dBc/Hz has been reported at 7 kHz offset with a OEO using a 15 km fiber loop. Phase noise is limited by the loop length. Such performance will improve the sub clutter visibility of Doppler RADAR systems and the bit error rate of high data rate communications systems. In fact, the source phase noise will ultimately determine the achievable cardinal performance of these systems.

The opto-electronic oscillator uses a long fiber loop as a high quality factor element in the optoelectronic loop comprising active electrical gain elements and passive loss. In order for oscillation to occur, the power gain of the loop must exceed the loss, and the phase change around the loop must be an integer multiple of 2 pi radians.

In a delay line oscillator, of which the optoelectronic oscillator is a specific embodiment, the oscillatory conditions are met at multiple frequencies spaced by the reciprocal of the delay. For example, a fiber of 5 km introduces a delay of about 23.3 microseconds, assuming the refractive index of the fiber is 1.4. As a consequence, oscillatory modes would be expected to occur at a frequency spacing of 43 kHz for frequencies from which the power gain condition for oscillation is satisfied.

In the case of a practical oscillator, a single output frequency is normally required. Single frequency operation necessitates a narrowband mode selection filter capable of isolating the mode of interest. At microwave frequencies a single pole resonator is used as a mode selection filter, having a monotonic phase slope with frequency over the passband. The gradient of the phase slope is dependent on the quality factor of the resonator. The resonator forces preferential selection of a single mode of the optoelectronic oscillator.

In spite of the selection of a single mode, adjacent modes can still store energy. This results in a multimode spurious spectrum, which is a common characteristic of delay line optoelectronic oscillators.

The unwanted adjacent modes are the main source of spurious signals in the opto-electronic oscillator and represent a periodic perturbation to the signal which can cause reduction in the system performance, such as sub clutter visibility and probability of false alarm in RADAR and bit error rate in communication systems.

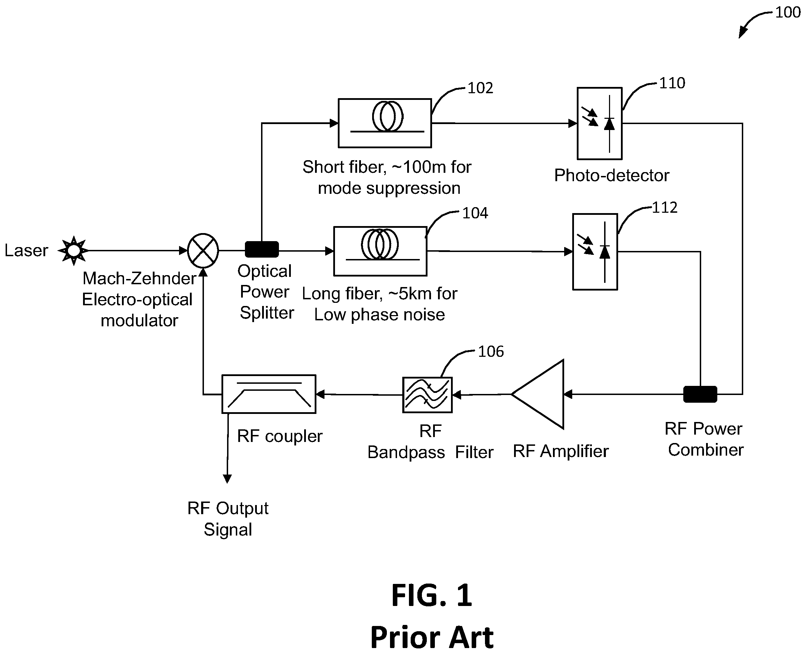

FIG. 1 is a block diagram of a known dual loop OEO 100 including a short fiber 102 and a long fiber 104 for providing a mode suppression circuit. The OEO of FIG. 1 suppresses the adjacent modes through inclusion of a second shorted optical delay line including short fiber 102 operated in parallel with the long delay line including long fiber 104. The short line 102 acts a filter having a mode spacing equal to the reciprocal of the delay. For example, a short delay line 102 of a length of 100 m would have a mode spacing of 2.14 MHz. The optical filter can thus reduce the passband requirement placed on the electrical filter to enable suppression of the unwanted mode. The short loop is used to provide lower Q factor resonance as compared with the long fiber. While the short fiber 102 suppresses modes adjacent to the oscillatory mode, it suffers the same resonant periodicity as the long fiber 104 and, as a result, transmission resonances occur at the free spectral range of the short fiber loop.

In the system of FIG. 1, the resonances from the short fiber loop are suppressed by the RF bandpass filter 106 which can have a wider bandwidth than would be required if just the long fiber loop was used. A double loop may also not be adequate to achieve the required level of mode suppression. Such a known approach requires an additional fiber 102, optical splitter 108 and photo-detectors 110 and 112, increasing the size and cost of the resultant equipment. Embodiments of the present disclosure solve this technical problem associated with this known approach.

Embodiments of the present disclosure provide a simple means to suppress the unwanted spurious modes by making use of a resonator as a frequency discriminator to discriminate between the required carrier signal and the unwanted modes. Embodiments of the present disclosure do not require additional fiber loops or optical components, making it a preferred implementation for spurious mode suppression.

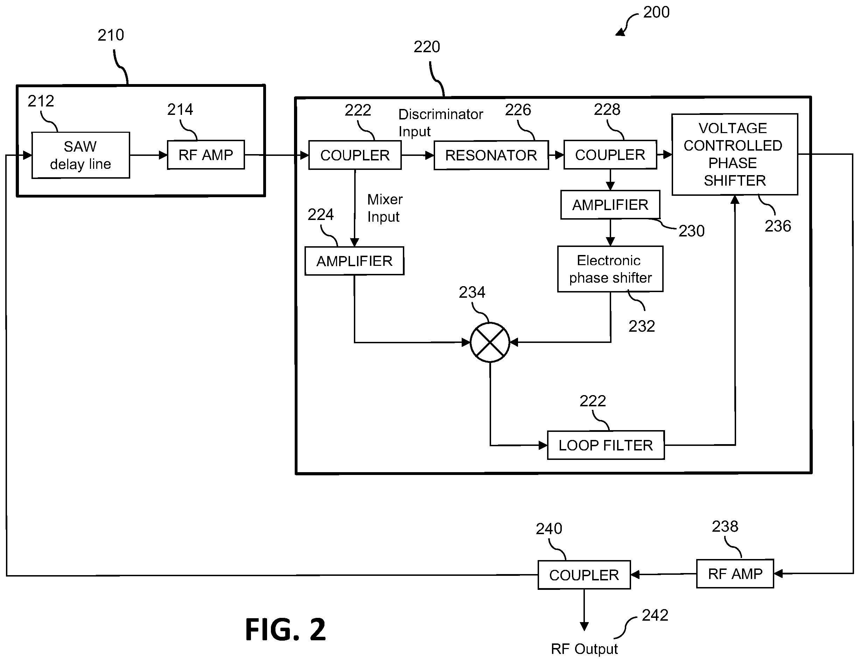

FIG. 2 is a block diagram of a circuit 200, such as an electrical oscillator with spurious suppression circuit, according to an embodiment of the present disclosure. In an implementation, the circuit of FIG. 2 is an all-electrical oscillator. The circuit may comprise a delay line oscillator 210 and a suppression circuit 220. The delay line oscillator 210 may comprise a surface acoustic wave (SAW) delay line 212 and an RF amplifier 214. The delay line 212 is configured to provide a delay line output. The delay line 212 may comprise an optical delay line. The delay line 212 may be characterized by a delay line length. The delay line output may include a plurality of oscillatory modes spaced apart based on a reciprocal of the loop time delay. The plurality of oscillatory modes may include a subset of oscillatory modes corresponding to a mode of the delay line output offset in phase from the center frequency.

The suppression circuit 220 may comprise a first coupler 222 configured to receive the delay line output and to generate a discriminator input signal and a mixer input signal. A first suppression circuit amplifier 224 may be configured to receive the output of the first coupler 222. A frequency discriminator 226 may be configured to receive the discriminator input , and provide a discriminator output having a plurality of oscillatory modes. The frequency discriminator 226 may comprise a resonator as shown in FIG. 2. The frequency discriminator may have an insertion phase error proportional to an offset from a center frequency. The center frequency may be a desired oscillatory mode.

A second coupler 228 may be configured to receive the discriminator output and to generate a first phase shifter input and a second phase shifter input. A second suppression circuit amplifier 230 may be configured to receive the output of the second coupler 228. A first phase shifter 232 may be configured to receive the discriminator output, such as an output from resonator 226, and apply a phase shift compensating for a mixer port phase differential. The second coupler 228, which may be referred to as a resonator coupler, may comprise a 10dB directional coupler. The second suppression circuit amplifier 230 may comprise a microwave amplifier used to increase the coupled signal to a power level sufficient to drive the mixer LO port. The first phase shifter 232 may comprise an electronic phase shifter as shown in FIG. 2.

A mixer 234 may be configured to provide a mixer output having a direct current (DC) component proportional to a phase difference between inputs received at first and second mixer ports. The first and second mixer ports may be offset in phase by the mixer port phase differential. The mixer port phase differential may comprise 90 degrees. The first mixer port may be configured to receive the delay line output, such as the output from the SAW delay line 212. The second mixer port may be configured to receive the discriminator output, such as the output from the resonator 226, via the first phase shifter 232. The mixer 234 may comprise a double balanced mixer, the first mixer port being in-phase and the second mixer port being in-quadrature relative to the first mixer port.

A second phase shifter 236 may be configured to receive the intermediate frequency output from the mixer 234 and provide a control signal based on the DC component, to modulate the phase of the outer loop, to counter multiple modes that may end up in the SAW delay line 212. The frequency discriminator or resonator 226 may pick out a plurality of modes around the oscillatory signal; one of the modes will land on the resonator frequency and won't have a phase shift, but the others will have a phase shift. The second phase shifter 236 may comprise a voltage controlled phase shifter. The second phase shifter 236 may provide its output to an RF amplifier 238 and then to a coupler 240. One output of the coupler 240 may be provided as the RF output 242 of the circuit 200, with the other output of the coupler 240 being fed back as an input to the delay line 210.

In the feedforward spurious suppression circuit of FIG. 2, a loop filter may be provided after the second phase shifter 236. The loop filter may be a low pass passive filter with a corner frequency of 120 MHz. Active loop filters may also be used to set a DC operating bias for the second phase shifter 236. In another embodiment, a loop filter 244 is coupled between the mixer 234 and the second phase shifter 236, and the loop filter 244 may be a low pass filter for filtering a non-DC component.

The resonator 226, which may be a mode selection resonator, may be configured to provide a monotonic phase slope with frequency and as such satisfies the oscillator phase condition at one frequency, the frequency of oscillation.

The established oscillation may excite additional modes spaced by the reciprocal of the delay, in the case of a 5 km fiber the mode spacing is approximately 43 kHz. The oscillatory loop may be set such that the oscillation condition is satisfied at the center frequency of the resonator 226 at which the insertion phase is zero degrees.

At the oscillation frequency, the insertion phase of the resonator 226 may be close to zero, leading to a minimum in the intermediate frequency (IF) DC voltage at quadrature. In the case of all other resonant modes, these represent a variation in phase across the resonator 226, leading to a voltage at the IF port of the mixer which is proportional to the phase modulation resulting from the multiple modes present in the oscillatory loop spaced by integer multiples of the reciprocal of the fiber length, index of refraction having been accounted for.

The oscillatory signal may see zero phase change through the resonator 226, the signal phase at the input of the resonator being equal to the signal phase at the output of the resonator 226. At the oscillatory mode, the phase change around the loop may be an integer multiple of 2 pi radians. The input and output signal to and from the resonator 226 may be fed to a double balanced mixer 234 which acts as a phase detector.

In an example embodiment, one tenth of the input signal to the mixer 234 is coupled to the RF port of the mixer, and one tenth of the output signal from the resonator 226 is coupled to a voltage controlled phase shifter 236 and then into the second suppression circuit amplifier 230 before being applied to the LO port of the mixer 234.

The voltage controlled phase shifter 236 may be adjusted to set quadrature phase alignment between the RF and local oscillator (LO) signals. If the phase difference between the RF and LO signals is 90 degrees, then the mixer IF port output may contain a DC level and a signal at the sum of the LO and RF signal frequencies. A low pass filter may be used to remove the sum frequency signal whilst passing the DC signal which is proportional to the phase difference between the LO and RF port signals.

The DC voltage may be applied as the control signal to a voltage controlled phase shifter 236 placed after a resonator output coupler 228. A circuit or network so configured according to an embodiment of the present disclosure enables feedforward cancellation of the phase modulation resulting from the parasitic multi-mode excitation present in the electro-optical loop. The electro-optic oscillator is a specific embodiment of a general class of oscillators which utilize the frequency selective characteristic of delay lines to achieve the required spectral performance.

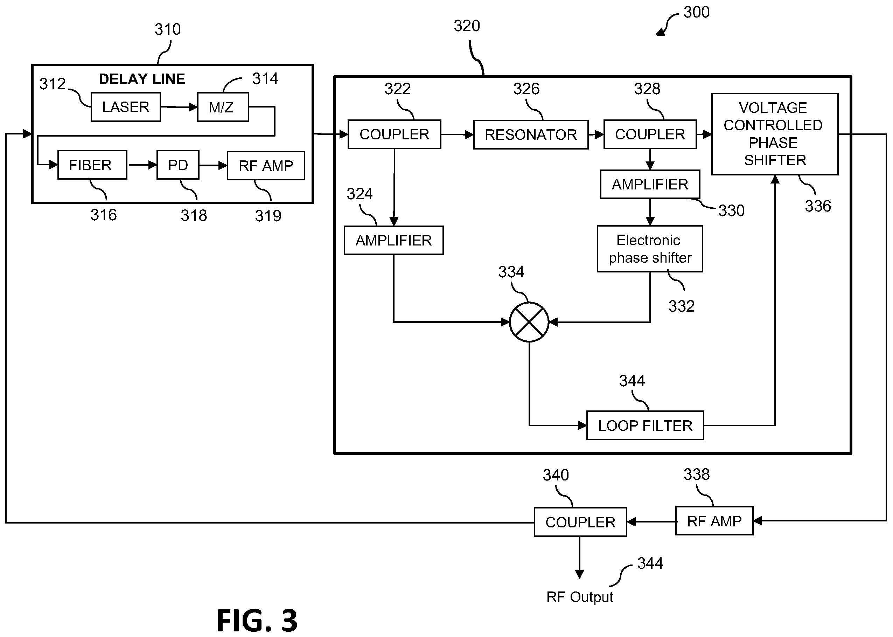

FIG. 3 is a block diagram of a circuit 300, such as an optical oscillator with spurious suppression circuit, according to an embodiment of the present disclosure. In an implementation, the circuit of FIG. 3 is an optical oscillator. The embodiment of FIG. 3 includes components of a delay line oscillator 310 that are similar to the delay line oscillator 210 in FIG. 2, and for which a detailed description is omitted herein, including RF amplifier 319, which is similar to RF amp 214 in FIG. 2, and delay line or fiber 316 similar to delay line 212. Suppression circuit 320 includes components that are similar to the suppression circuit 220 of FIG. 2 and for which a detailed description is omitted herein, including first coupler 322, first suppression circuit amplifier 324, frequency discriminator or resonator 326, second coupler 328, second suppression circuit amplifier 330, first phase shifter or electronic phase shifter 332, mixer 334, second phase shifter or voltage controlled phase shifter 336, RF amplifier 338, coupler 340, RF output 342 and loop filter 344. RF amplifiers 319 and 338 may be configured to provide sufficient loop gain to meet the oscillatory condition. RF amplifier 319 may be configured to boost the signal detected at the output of the optical fiber 316.

In an example embodiment, the circuit may comprise a set of optical domain components comprising an optical laser 312, a fiber or delay line 316, a photodetector 318 which acts to downconvert the optical signal to the electrical domain and an electro-optical Mach-Zehnder intensity modulator 314 which enables modulation of the optical signal by the electrical oscillation signal. The opto-electronic downconverter or delay line oscillator 310 may be configured to receive and convert the delay line optical output to an RF domain, and may include a photo detector such as a photodiode (PD) and an RF amplifier. The opto- electronic modulator may be configured to receive the control signal from the second phase shifter 336. The modulator may comprise a Mach-Zehnder modulator. The laser 312 may be provided as part of a signal source. The delay line oscillator 310 may be configured purely in the electrical domain in which case the signal source would be an electrical oscillator and the modulator would be a voltage variable attenuator. Further the oscillator can be configured as in FIG. 2 in which an external source is not required and the oscillatory loop is formed through the RF amplifier 212 and SAW delay line 214.

With respect to FIG. 3, the photo detector 318 may constitute a down converter as it extracts the amplitude modulation envelope from the optical signal. The M/Z (Mach-Zehnder) modulator 314 may constitute the modulator in FIG. 3. The modulation signal may be the electrical oscillatory signal.

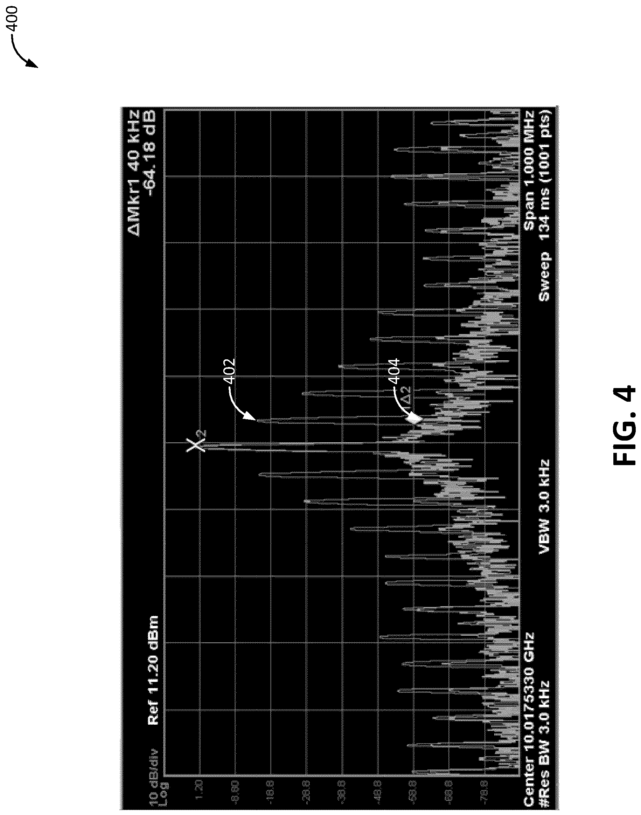

FIG. 4 is a graph 400 showing spurious signals and the measured performance of a feedforward multimode spurious suppression circuit according to an embodiment of the present disclosure. In FIG. 4, a first trace 402 shows the spurious signals with the suppression circuit turned off. The second trace 404 shows the spurious signals resulting when the suppression circuit is turned on. Spurious suppression of 45 dB is seen achieved by embodiments of the present disclosure when considering the spurious signal amplitude with the suppression circuit turned on, compared to when the circuit is turned off. The example of FIG. 4 relates to a scenario where a spectrum analyzer has a 3.0 kHz resolution bandwidth, analyzing a delay line with a center frequency of 10.0 GHz.

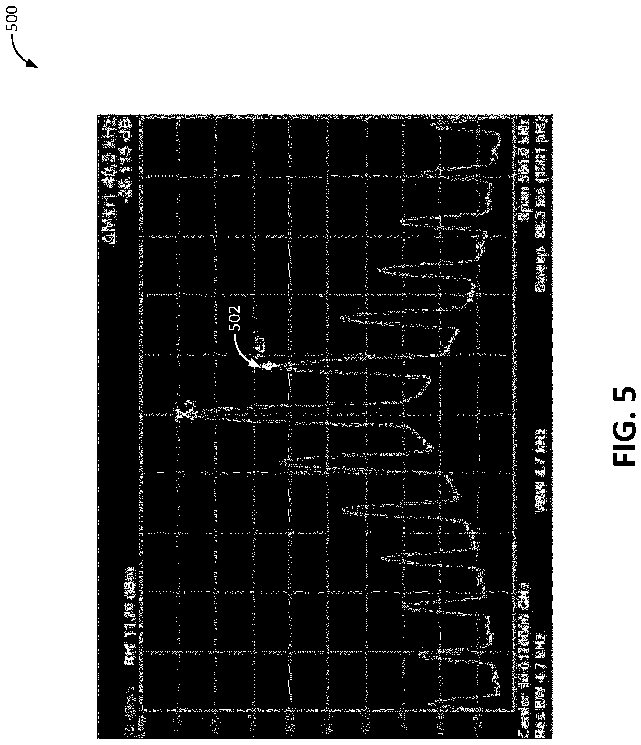

FIG. 5 is a graph showing spurious signals without suppression in an implementation. FIG. 5 shows a trace 502 with spurious suppression de-activated leading to high spurious levels at -25dBc, for example as shown on the trace 502. The example of FIG. 5 relates to a scenario where a spectrum analyzer has a 4.7 kHz resolution bandwidth, analyzing a delay line with a center frequency of 10.0 GHz.

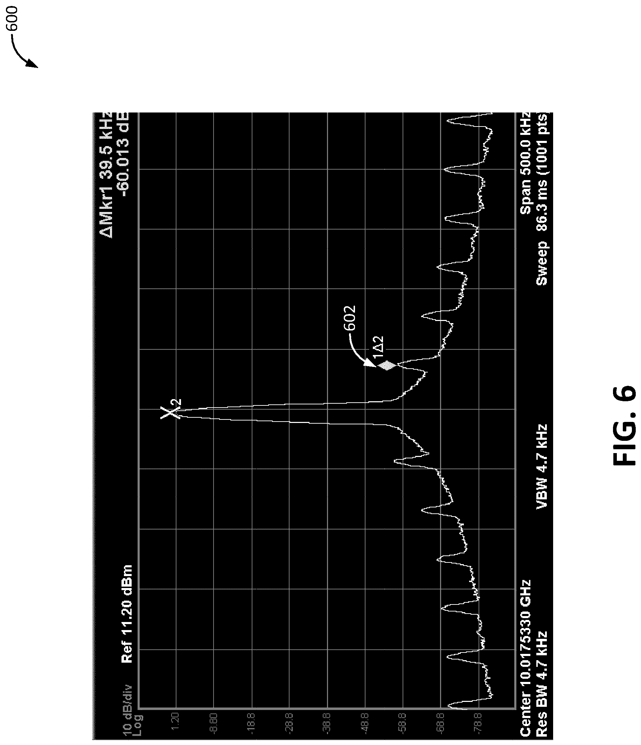

FIG. 6 is a graph showing the measured performance of a feedforward multimode spurious suppression circuit applied to the spurious signals of FIG. 5 according to an embodiment of the present disclosure. In FIG. 6, the spurious suppression circuit has been turned on and a trace 602 shows that spurs are reduced by 45 dB to -60 dBc.

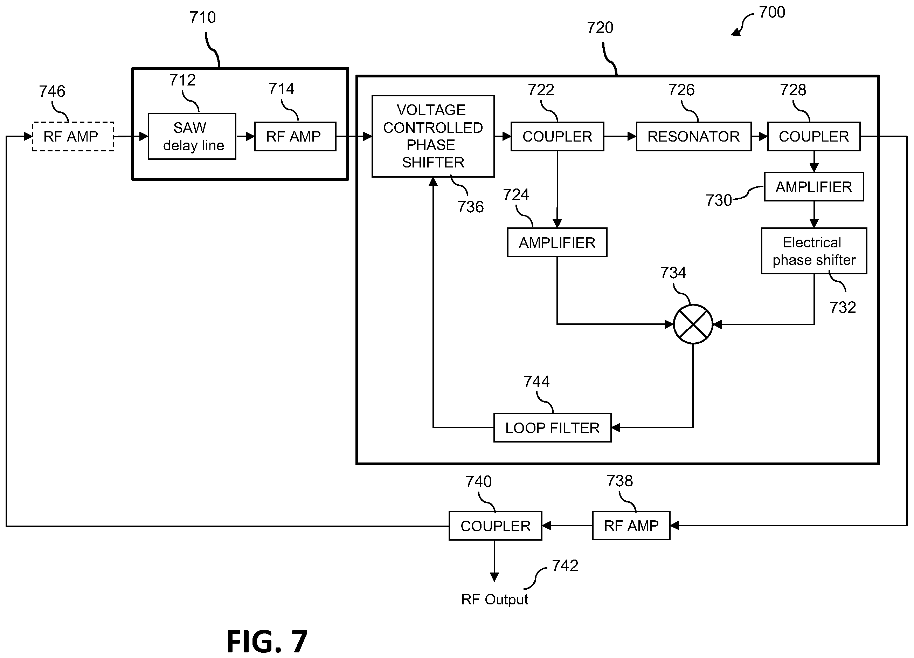

FIG. 7 is a block diagram of a circuit 700, such as an electrical oscillator with spurious suppression circuit with a feedback architecture to suppress spurs, according to an embodiment of the present disclosure. The circuit 700 may comprise components of a delay line oscillator 710 that are similar to the delay line oscillator 210 in FIG. 2, and for which a detailed description is omitted herein, including delay line or fiber 712 and RF amplifier 714. Suppression circuit 720 includes components that are similar to the suppression circuit 220 of FIG. 2 and for which a detailed description is omitted herein, including first coupler 722, first suppression circuit amplifier 724, frequency discriminator or resonator 726, second coupler 728, second suppression circuit amplifier 730, first phase shifter or electronic phase shifter 732, mixer 734, second phase shifter or voltage controlled phase shifter 736, RF amplifier 738, coupler 740, RF output 742 and loop filter 744, as well as optional RF amplifier 746.

In the embodiment of FIG. 7, a feedback architecture is provided to suppress spurs. The embodiment of FIG 7 employs all electrical components to establish the delay line oscillator. As shown in FIG. 7, the second phase shifter or voltage controlled phase shifter 736 is provided between the loop filter 744 and the frequency discriminator or resonator 726. In this embodiment, the second phase shifter 736 has as a first input the output of the loop filter 744, and as a second input the output of the delay line 712, for example via RF amplifier 714. The output of the second phase shifter 736 is provided to the resonator 726, for example via a coupler 722. This is in contrast to FIG. 2, in which the second phase shifter has as a second input the coupler 218, and the output of the second phase shifter 212 is provided to the input of the delay line 204 via the RF amplifier 202. The resonator 726 introduces a phase difference between its input and output for signals that differ from the resonance frequency. The phase difference is established for spurious modes. The phase difference signals are converted to a voltage difference when applied to the mixer 734. The voltage signal output from mixer 734 is filtered using low pass filter 744 before being applied to the voltage controlled phase shifter 736. The phase shifter forms a closed feedback loop that operates to reduce the spurious mode signal amplitude.

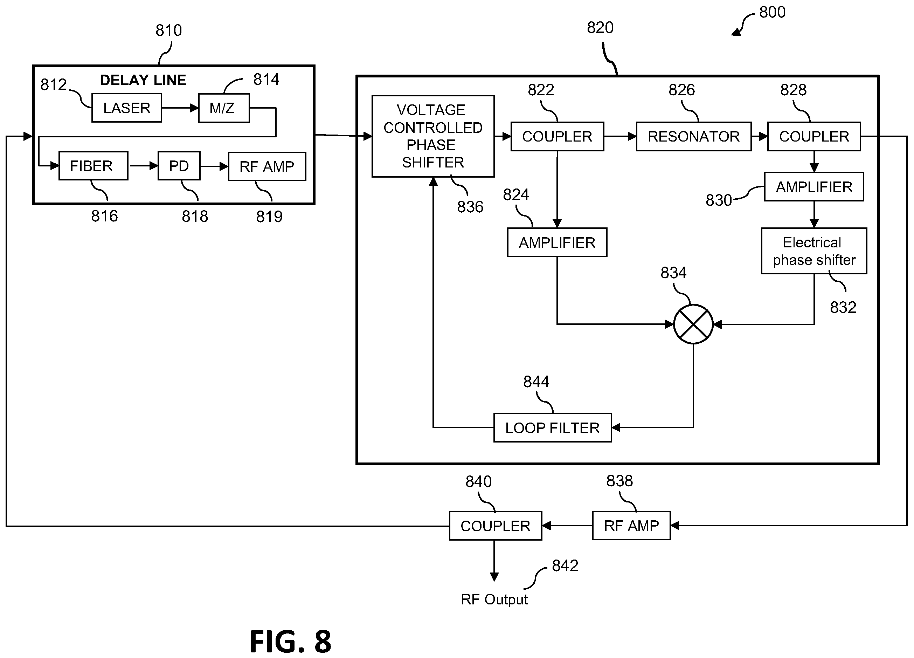

FIG. 8 is a block diagram of a circuit 800, such as an opto-electronic circuit or an optical oscillator with spurious suppression circuit with a feedback architecture to suppress spurs, according to an embodiment of the present disclosure. The embodiment of FIG. 8 is a similar circuit layout to FIG. 3 and includes components of a delay line oscillator 810 that are similar to the delay line oscillator 310 in FIG. 3, and for which a detailed description is omitted herein, including optical laser 812, electro-optical Mach-Zehnder intensity modulator 814, optical fiber 816, photodetector 818 and RF amplifier 819. Suppression circuit 820 includes components that are similar to the suppression circuit 320 of FIG. 3 and for which a detailed description is omitted herein, including first coupler 822, first suppression circuit amplifier 824, frequency discriminator or resonator 826, second coupler 828, second suppression circuit amplifier 830, first phase shifter or electronic phase shifter 832, mixer 834, second phase shifter or voltage controlled phase shifter 836, RF amplifier 838, coupler 840, RF output 842 and loop filter 844.

In the embodiment of FIG. 8, a feedback architecture is provided to suppress spurs. As shown in FIG. 8, the second phase shifter or voltage controlled phase shifter 836 is provided between the loop filter 844 and the frequency discriminator or resonator 826. In this embodiment, the second phase shifter 836 has as a first input the output of the loop filter 844, and as a second input the output of the delay line 812, for example via photodiode (PD) 818 and an RF amplifier 819. The output of the second phase shifter 836 is provided to the resonator 826, for example via a coupler. This is in contrast to FIG. 3, in which the second phase shifter has as a second input the coupler 328, and the output of the second phase shifter 336 is provided to the input of the delay line oscillator 310.

As shown in FIG. 8, a signal entering the resonator 826 having a frequency that is different from the resonant frequency will establish a phase difference between the signal entering resonator 826 and the signal leaving resonator 826. The input and output signals to resonator 826 are coupled to mixer 834. The signals that enter mixer 834 that are not phase aligned establish a control signal at the IF output of mixer 834. The IF signal of mixer 834 is passed through low pass filter 844 to remove the upper sideband signals and leave the low frequency control signal. The control signal is applied to voltage controlled phase shifter 836 resulting in suppression of off resonance signals.

In the embodiments of FIG. 7 and/or FIG. 8, the loop filter may be a passive low pass filter with a corner frequency of 120MHz. Active loop filters may also be used to set a DC operating bias for the voltage controlled phase shifter.

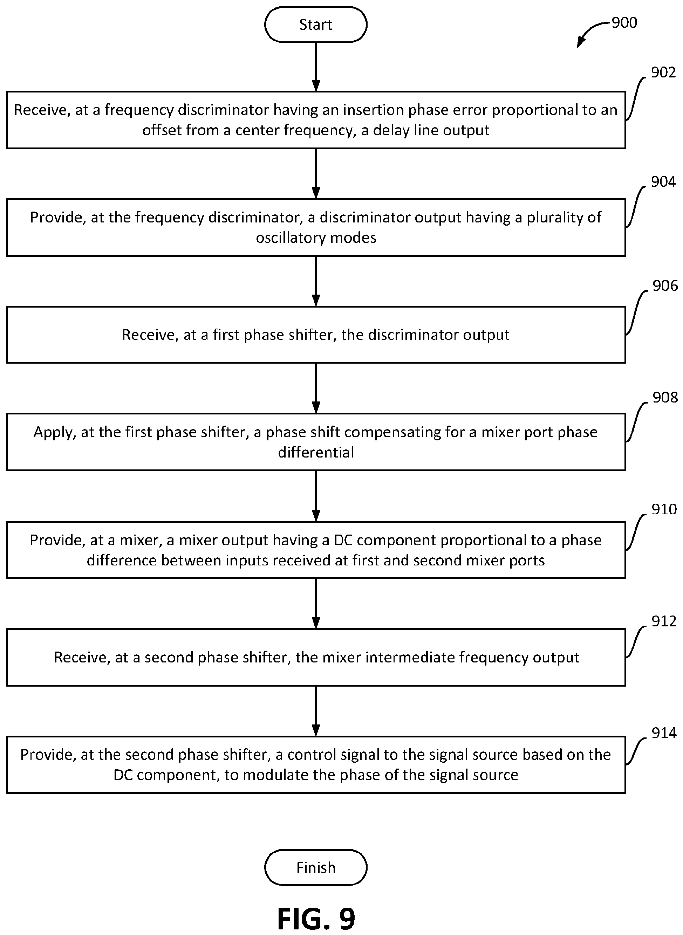

FIG. 9 is a flow chart illustrating a method 900 of spurious signal suppression, according to an embodiment of the present disclosure. Embodiments of the present disclosure provide a method for suppressing modes spaced by the reciprocal of the oscillator delay that are not located at the center frequency of the mode selection filter that sets the oscillatory mode.

As shown in FIG. 9, the method 900 may comprise, at 902, receiving, at a frequency discriminator having an insertion phase error proportional to an offset from a center frequency, a delay line output. The method 900 may comprise, at 904, providing, at the frequency discriminator, a discriminator output having a plurality of oscillatory modes. The method 900 may comprise, at 906, receiving, at a first phase shifter, the discriminator output. The method 900 may comprise, at 908, applying, at the first phase shifter, a phase shift compensating for a mixer port phase differential.

The method 900 may comprise, at 910, providing, at a mixer, a mixer output having a DC component proportional to a phase difference between inputs received at first and second mixer ports, the first and second mixer ports being offset in phase by the mixer port phase differential, the first mixer port configured to receive the delay line output and the second mixer port configured to receive the discriminator output. The method 900 may comprise, at 912, receiving, at a second phase shifter, the mixer intermediate frequency output. The method 900 may comprise, at 914, providing, at the second phase shifter, a control signal to the signal source based on the DC component, to modulate the phase of the signal source.

In another embodiment, the present disclosure provides a processor-implemented method of spurious signal suppression, comprising: receiving a delay line output; providing a discriminator output having a plurality of oscillatory modes; receiving the discriminator output; applying a phase shift compensating for a mixer port phase differential; providing a mixer output having a DC component proportional to a phase difference between inputs received at first and second mixer ports, the first and second mixer ports being offset in phase by the mixer port phase differential, the first mixer port configured to receive the delay line output and the second mixer port configured to receive the discriminator output; receiving the mixer intermediate frequency output; and providing a control signal to the signal source based on the DC component, to modulate the phase of the signal source.

In a further embodiment, the present disclosure provides a non-transient computer-readable storage medium having instructions embodied thereon, the instructions being executable by one or more processors to perform a method of spurious signal suppression, the method comprising: receiving, at a frequency processor having an insertion phase error proportional to an offset from a center frequency, a delay processor output; providing, at the frequency processor , a frequency processor output having a plurality of oscillatory modes; receiving, at a first phase processor, the frequency processor output; applying, at the first phase processor, a phase shift compensating for a signal processor port phase differential; providing, at a signal processor , a signal processor output having a DC component proportional to a phase difference between inputs received at first and second signal processor, the first and second signal processor ports being offset in phase by the signal processor port phase differential, the first signal processor port configured to receive the delay processor output and the second signal processor port configured to receive the frequency processor output; receiving, at a second phase shifter, the signal processor intermediate frequency output; and providing, at the second phase processor, a control signal to the signal source based on the DC component, to modulate the phase of the signal source.

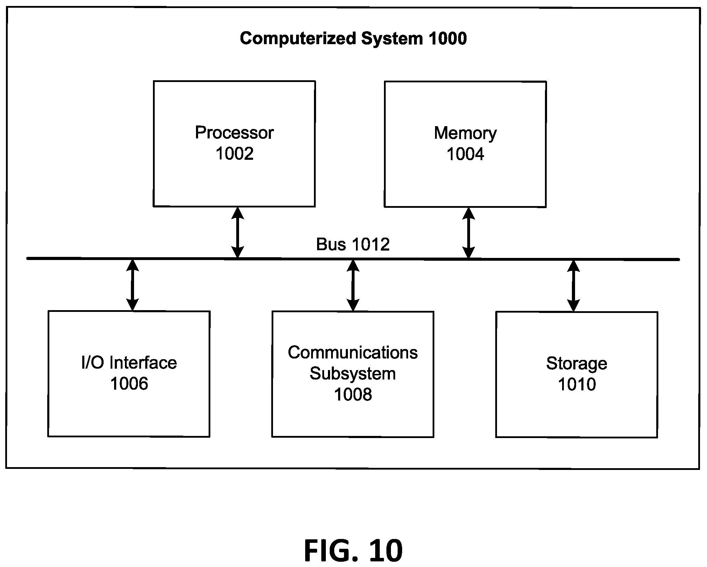

FIG. 10 is a block diagram of an example computerized device or system that may be used in implementing one or more aspects or components of an embodiment of a spurious suppression circuit in accordance with embodiment of the present disclosure, for example implementing one or more elements, or sub-components, as described in relation to the spurious suppression circuit providing functionality similar to that shown in FIG. 2, FIG. 3, FIG. 7 and/or FIG. 8, and/or for implementing one or more operations of methods based on the functions of such circuit(s).

Computerized system 1000 may include one or more of a processor 1002, memory 1004, a mass storage device 1010, an input/output (I/O) interface 1006, and a communications subsystem 1008. Further, system 1000 may comprise multiples, for example multiple processors 1002, and/or multiple memories 1004, etc. Processor 1002 may comprise one or more of a digital processor, an analog processor, a digital circuit designed to process information, an analog circuit designed to process information, a state machine, and/or other mechanisms for electronically processing information. These processing units may be physically located within the same device, or the processor 1002 may represent processing functionality of a plurality of devices operating in coordination. The processor 1002 may be configured to execute modules by software; hardware; firmware; some combination of software, hardware, and/or firmware; and/or other mechanisms for configuring processing capabilities on the processor 1002, or to otherwise perform the functionality attributed to the module and may include one or more physical processors during execution of processor readable instructions, the processor readable instructions, circuitry, hardware, storage media, or any other components.

One or more of the components or subsystems of computerized system 1000 may be interconnected by way of one or more buses 1012 or in any other suitable manner.

The bus 1012 may be one or more of any type of several bus architectures including a memory bus, storage bus, memory controller bus, peripheral bus, or the like. The CPU 1002 may comprise any type of electronic data processor. The memory 1004 may comprise any type of system memory such as dynamic random access memory (DRAM), static random access memory (SRAM), synchronous DRAM (SDRAM), read-only memory (ROM), a combination thereof, or the like. In an embodiment, the memory may include ROM for use at boot-up, and DRAM for program and data storage for use while executing programs.

The mass storage device 1010 may comprise any type of storage device configured to store data, programs, and other information and to make the data, programs, and other information accessible via the bus 1012. The mass storage device 1010 may comprise one or more of a solid state drive, hard disk drive, a magnetic disk drive, an optical disk drive, or the like. In some embodiments, data, programs, or other information may be stored remotely, for example in the cloud. Computerized system 1000 may send or receive information to the remote storage in any suitable way, including via communications subsystem 1008 over a network or other data communication medium.

The I/O interface 1006 may provide interfaces for enabling wired and/or wireless communications between computerized system 1000 and one or more other devices or systems. For instance, I/O interface 1006 may be used to communicatively couple with sensors, such as cameras or video cameras. Furthermore, additional or fewer interfaces may be utilized. For example, one or more serial interfaces such as Universal Serial Bus (USB) (not shown) may be provided.

Computerized system 1000 may be used to configure, operate, control, monitor, sense, and/or adjust devices, systems, and/or methods according to the present disclosure.

A communications subsystem 1008 may be provided for one or both of transmitting and receiving signals over any form or medium of digital data communication, including a communication network. Examples of communication networks include a local area network (LAN), a wide area network (WAN), an inter-network such as the Internet, and peer-to-peer networks such as ad hoc peer-to-peer networks. Communications subsystem 1008 may include any component or collection of components for enabling communications over one or more wired and wireless interfaces. These interfaces may include but are not limited to USB, Ethernet (e.g. IEEE 802.3), high-definition multimedia interface (HDMI), Firewire^{™} (e.g. IEEE 1394), Thunderbolt^{™}, WiFi^{™} (e.g. IEEE 802.11), WiMAX (e.g. IEEE 802.16), Bluetooth^{™}, or Near-field communications (NFC), as well as GPRS, UMTS, LTE, LTE-A, and dedicated short range communication (DSRC). Communication subsystem 1008 may include one or more ports or other components (not shown) for one or more wired connections. Additionally or alternatively, communication subsystem 1008 may include one or more transmitters, receivers, and/or antenna elements (none of which are shown).

Computerized system 1000 of FIG. 10 is merely an example and is not meant to be limiting. Various embodiments may utilize some or all of the components shown or described. Some embodiments may use other components not shown or described but known to persons skilled in the art.

In the preceding description, for purposes of explanation, numerous details are set forth in order to provide a thorough understanding of the embodiments. However, it will be apparent to one skilled in the art that these specific details are not required. In other instances, well-known electrical structures and circuits are shown in block diagram form in order not to obscure the understanding. For example, specific details are not provided as to whether the embodiments described herein are implemented as a software routine, hardware circuit, firmware, or a combination thereof.

Embodiments of the disclosure can be represented as a computer program product stored in a machine-readable medium (also referred to as a computer-readable medium, a processor-readable medium, or a computer usable medium having a computer-readable program code embodied therein). The machine-readable medium can be any suitable tangible, non-transitory medium, including magnetic, optical, or electrical storage medium including a diskette, compact disk read only memory (CD-ROM), memory device (volatile or non-volatile), or similar storage mechanism. The machine-readable medium can contain various sets of instructions, code sequences, configuration information, or other data, which, when executed, cause a processor to perform steps in a method according to an embodiment of the disclosure. Those of ordinary skill in the art will appreciate that other instructions and operations necessary to implement the described implementations can also be stored on the machine-readable medium. The instructions stored on the machine-readable medium can be executed by a processor or other suitable processing device, and can interface with circuitry to perform the described tasks.

The above-described embodiments are intended to be examples only. Alterations, modifications and variations can be effected to the particular embodiments by those of skill in the art without departing from the scope, which is defined solely by the claims appended hereto.

## Claims

1. A circuit, comprising:
a delay line configured to provide a delay line output;
a first coupler configured to receive the delay line output and to generate a discriminator input signal and a mixer input signal;
a frequency discriminator having an insertion phase error proportional to an offset from a center frequency, the frequency discriminator configured to receive the discriminator input signal and provide a discriminator output having a plurality of oscillatory modes;
a second coupler configured to receive the discriminator output and to generate a first phase shifter input and a second phase shifter input;
a first phase shifter configured to receive the first phase shifter input and apply a phase shift establishing a mixer port phase differential and to generate a first phase shifter output;
a mixer configured to provide a mixer output having a DC component proportional to a phase difference between inputs received at first and second mixer ports, the first and second mixer ports being offset in phase by the mixer port phase differential, the first mixer port configured to receive the mixer input signal and the second mixer port configured to receive the first phase shifter output;
a second phase shifter configured to receive the mixer output and to phase modulate the second phase shifter input based on the DC component and to output a phase modulated signal;
an RF amplifier configured to receive the phase modulated signal, and output an amplified phase modulated signal to an input of the delay line; and
a circuit coupler configured to receive the amplified phase modulated signal and to provide a first circuit coupler output as an RF output of the circuit, and to provide a second circuit coupler output as an input to the delay line.

2. The circuit of claim 1, further comprising:
a first suppression circuit amplifier configured to receive the discriminator input signal from the first coupler and to provide an amplified discriminator input signal to the frequency discriminator; and
a second suppression circuit amplifier configured to receive the first phase shifter input of the second coupler and to provide an amplified first phase shifter input to the first phase shifter.

3. The circuit of claim 1, further comprising a low pass filter coupled between the mixer and the second phase shifter, the low pass filter for filtering a non-DC component.

4. The circuit of any one of claims 1 to 3, wherein the mixer comprises a double balanced mixer, the first mixer port being in-phase and the second mixer port being in-quadrature relative to the first mixer port.

5. The circuit of any one of claims 1 to 4, wherein the mixer port phase differential comprises 90 degrees.

6. The circuit of any one of claims 1 to 5, wherein the delay line is **characterized by** a delay line length and the delay line output includes a plurality of oscillatory modes spaced apart based on a reciprocal of the delay line length, and , wherein the plurality of oscillatory modes includes a subset of oscillatory modes corresponding to a mode of the delay line output offset in phase from the center frequency.

7. The circuit of any one of claims 1 to 6, wherein the center frequency is a desired oscillatory mode.

8. The circuit of any one of claims 1 to 7, wherein the first phase shifter comprises an electronic phase shifter and the second phase shifter comprises a voltage controlled phase shifter.

9. The circuit of any one of claims 1 to 8, wherein the signal source comprises a surface acoustic wave oscillator.

10. The circuit of any one of claims 1 to 8, further comprising a set of optical domain components comprising the signal source, the delay line, a downconverter and a modulator, the downconverter configured to receive and convert the delay line output to an **RF** domain and the modulator configured to receive the control signal from the second phase shifter, wherein the signal sources comprises a laser and the delay line comprises an optical delay line.

11. The circuit of claim 10, wherein the downconverter comprises a photodiode.

12. The circuit of claim 10 or claim 11, wherein the modulator comprises a Mach-Zehnder modulator.

13. A method of spurious signal suppression, comprising:
receiving, at a frequency discriminator having an insertion phase error proportional to an offset from a center frequency, a delay line output;
providing, at the frequency discriminator, a discriminator output having a plurality of oscillatory modes;
receiving, at a first phase shifter, the discriminator output;
applying, at the first phase shifter, a phase shift compensating for a mixer port phase differential;
providing, at a mixer, a mixer output having a DC component proportional to a phase difference between inputs received at first and second mixer ports, the first and second mixer ports being offset in phase by the mixer port phase differential, the first mixer port configured to receive the delay line output and the second mixer port configured to receive the discriminator output;
receiving, at a second phase shifter, the mixer intermediate frequency output;
providing, at the second phase shifter, a phase modulated signal;
receiving, at a circuit coupler, the phase modulated signal; and
providing, at the circuit coupler, a first circuit coupler output as an RF output of the circuit, and a second circuit coupler output as an input to the delay line.

14. A non-transient computer-readable storage medium having instructions embodied thereon, the instructions being executable by one or more processors to perform a method of spurious signal suppression, the method comprising:
receiving, at a frequency discriminator having an insertion phase error proportional to an offset from a center frequency, a delay line output;
providing, at the frequency discriminator, a discriminator output having a plurality of oscillatory modes;
receiving, at a first phase shifter, the discriminator output;
applying, at the first phase shifter, a phase shift compensating for a mixer port phase differential;
providing, at a mixer, a mixer output having a DC component proportional to a phase difference between inputs received at first and second mixer ports, the first and second mixer ports being offset in phase by the mixer port phase differential, the first mixer port configured to receive the delay line output and the second mixer port configured to receive the discriminator output;
receiving, at a second phase shifter, the mixer intermediate frequency output;
providing, at the second phase shifter, a phase modulated signal;
receiving, at a circuit coupler, phase modulated signal; and
providing, at the circuit coupler, a first circuit coupler output as an RF output of the circuit, and a second circuit coupler output as an input to the delay line.

15. A circuit, comprising:
a delay line configured to provide a delay line output;
a voltage-controlled phase shifter configured to receive the delay line output and to phase modulate the delay line output and to output a phase modulated signal;
a first coupler configured to receive phase modulated signal and to generate a discriminator input signal and a mixer input signal;
a frequency discriminator having an insertion phase error proportional to an offset from a center frequency, the frequency discriminator configured to receive the discriminator input signal and provide a discriminator output having a plurality of oscillatory modes;
a second coupler configured to receive the discriminator output and to generate a first phase shifter input and a second coupler output;
an electronic phase shifter configured to receive the first phase shifter input and apply a phase shift establishing a mixer port phase differential and to generate a first phase shifter output;
a mixer configured to provide a mixer output having a DC component proportional to a phase difference between inputs received at first and second mixer ports, the first and second mixer ports being offset in phase by the mixer port phase differential, the first mixer port configured to receive the mixer input signal and the second mixer port configured to receive the first phase shifter output;
an RF amplifier configured to receive the second coupler output, and output an amplified phase modulated signal to an input of the delay line; and
a circuit coupler configured to receive the amplified phase modulated signal and to provide a first circuit coupler output as an RF output of the circuit, and to provide a second circuit coupler output as an input to the delay line.
